Europäisches Patentamt

European Patent Office

Office européen des brevets

(11) Publication number: **0 073 019**
**A2**

# (12) EUROPEAN PATENT APPLICATION

(21) Application number: **82107545.4**

(22) Date of filing: **18.08.82**

(51) Int. Cl.³: **H 01 L 27/10**
**G 11 C 11/24, H 01 L 21/82**

(30) Priority: **18.08.81 JP 129041/81**

(43) Date of publication of application:
**02.03.83 Bulletin 83/9**

(84) Designated Contracting States:
**DE FR GB**

(71) Applicant: **NIPPON ELECTRIC CO., LTD.**
**33-1, Shiba Gochome, Minato-ku**
**Tokyo, 108(JP)**

(72) Inventor: **Fujii, Takeo**
**c/o Nippon Electric Co., Ltd. 33-1, Shiba Gochome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) Memory device and process for manufacturing the same.

(57) A memory device including memory cells each consisting of a single transistor and a single capacitor is disclosed, in which a large number of active regions of clavicle-like shape in a plan configuration surrounded by a field region are arrayed as interlaced with each other. Each active region includes a common source or drain region connected to a data line, and channel regions and capacitor regions on the both sides of the common region. Capacitor electrodes, gate electrodes and data lines are formed from first, second and third polycrystalline silicon layers, respectively. Owing to the above-mentioned novel construction, reduction of a stray capacitance of a data line and increase in a capacitance of a capacitor section can be realized simultaneously with high density circuit integration.

Fig.8B

MEMORY DEVICE AND PROCESS

FOR MANUFACTURING THE SAME

BACKGROUND OF THE INVENTION:

The present invention relates to a memory device and more particularly, to a memory device in which each memory cell is composed of a single insulated gate field effect transistor and a single capacitor and a process for manufacturing such a memory device.

The above-referred type of memory devices have been heretofore proposed in great numbers. However, in the prior art it was difficult to achieve high density circuit integration by reducing a ratio $C_D/C_S$ of a stray capacitance $C_D$ of a data line to a capacitance $C_S$ of a capacitor section to a small value. For instance, British Patent Specification No. 1,374,009 discloses a device in which a metallic data line is connected to an island-shaped impurity region (source or drain region) that is common to two memory cells juxtaposed in one direction, and a device in which an impurity region provided in a semiconductor substrate as extending in one direction is used as a data line. However, in these disclosed devices, a large field region is provided between adjacent memory cells aligned in one direction, and the impurity region would not serve as a common source or drain region of the memory cells on the left and right sides.

Accordingly, it is impossible to achieve high density circuit integration by reducing the ratio $C_D/C_S$ to a small value. In addition, in a memory device disclosed in British Patent Specification No. 1,516,005, one common impurity region is used as a source or drain region that is common to the memory cells on the left and right sides. However, even in this case also, no attention is paid to the similar problem occurring between memory cells aligned in one direction (in a longitudinal direction). As described above, the memory devices in the prior arts are not optimized in layout, and hence they do not effectively utilize the surface of a semiconductor substrate. Whereas, in a memory device disclosed in U.S. Patent 4,012,757 granted to James T. Koo, trial was made for optimizing the above-mentioned layout. In this proposed memory device, finger-like active regions are projected from each impurity diffused region provided in a semiconductor substrate as extending one direction and serving as a data line, and the active regions projecting from different impurity diffused regions are interlaced. However, this known memory device has a large stray capacitance $C_D$ because the aforementioned impurity diffused regions are used as data lines in the device. Moreover, since a field insulating film partly buried in a semiconductor device is necessitated between a capacitor section within an active region of one memory cell and an adjacent data line connected to other memory cells, the area of the capacitor section is reduced by the corresponding amount, and hence the capacitance $C_S$ of the capacitor section would become small. More specifically, since the length of the field insulating film between the above-mentioned active region and the above-described data line is required to be as long as 2 ~ 3 μm and hence the distance between capacitor sections of opposed memory cells with a data line interposed therebetween is as large as about 9 μm, reduction of a capacitance due to the presence of the field insulating film serves as a great factor of fail in realization of an optimum layout.

SUMMARY OF THE INVENTION:

It is one object of the present invention is to provice an improved memory device which is free from the above-described shortcomings in the prior art.

Another object of the present invention is to provide a novel process for manufacturing the aimed improved memory device.

According to one feature of the present invention, there is provided a memory device in which a large number of memory cells are arrayed in a matrix form, comprising a semiconductor substrate of one conductivity type, a field region including a thick insulating film provided along one major surface of the semiconductor substrate, a large number of active regions arrayed in a matrix form, each active region having a plan configuration including wide sections serving as capacitor regions contiguous to the opposite ends of a narrow section and surrounded by the field region, impurity regions of the opposite conductivity type provided at the centers of the narrow sections of the respective active regions and serving as source or drain regions, first and second channel regions positioned in the portions of the narrow sections which are contiguous to the opposite sides of the impurity regions, capacitor electrodes including a first polycrystalline silicon layer provided via a first insulating film above the active regions except for the impurity regions and the first and second channel regions and provided substantially over the entire surface of the field region, gate electrodes including a second polycrystalline silicon layer disposed above the first channel regions of the respective active regions via a gate insulating film and extending over the first polycrystalline silicon layer via a second insulating film to be disposed above the second channel regions of the adjacent active regions via a gate insulating film, a large number of data lines including a third polycrystalline silicon layer connecting in common with the impurity regions of a group of active regions arrayed in one direction and extending in one direction over the first polycrystalline silicon layer on the field region between the respective active regions via a third insulating film, and a large number of word lines extending in the direction at right angles to the one direction and connecting with the respective gate electrodes.

According to another feature of the present invention, there is provided a memory device comprising a semiconductor substrate of one conductivity type, a field region including a thick insulating film provided along one major surface of the semiconductor substrate, a first group of active regions arrayed in a matrix form as aligned in predetermined orthogonal directions, each said active region having a plan configuration including a narrow section having first and second edge lines which are substantially parallel to each other and wide sections provided contiguously to the opposite ends of the narrow section and surrounded by the field region, a second group of active regions arrayed in a matrix form as aligned in said predetermined orthogonal directions, each said active region having a plan configuration including a narrow section having first and second edge lines which are substantially parallel to each other and wide sections provided contiguously to the opposite ends of the narrow section and surrounded by the field region, the second group active regions being interlaced between the first group active regions in such manner that the wide section of the second group active region is opposed to the narrow section of the first group active region and the narrow section of the second group active region is opposed to the wide section of the first group active region, impurity regions of the opposite conductivity type provided at the centers of the narrow sections of the respective active regions and serving as source or drain regions, first and second channel regions positioned in the portions of the narrow sections contiguous to the impurity regions, capacitor electrodes including a first polycrystalline silicon layer provided via a first insulator film above the active regions except for the impurity region and the first and second channel regions and also provided substantially over the entire surface of the field region, a first group of gate electrodes including a second polycrystalline silicon layer, each the first group gate electrode being disposed above the first channel region of one first group active region via a gate insulating film and extending over the first polycrystalline silicon layer via a second insulating film to be disposed above said second channel region of the adjacent second group active region via a gate insulating film, a second group of gate electrodes including the second polycrystalline silicon layer, each the second group gate electrode being disposed above said second channel region of one second group active region via a gate insulating film and extending over the first polycrystalline silicon layer via a second insulating film to be disposed above the first channel region of the adjacent second group active region via a gate insulating film, a first group of data lines including a third polycrystalline silicon layer, each first group data line connecting with the respective impurity regions of the first group active regions aligned in one directions of the predetermined orthogonal directions and extending in the one direction over the first polycrystalline silicon layer on the field region in the proximity of the wide sections, in the plan view, surving as capacitor sections of the second group active regions via a third insulating film, a second group of data lines including the third polycrystalline silicon layer, each second group data line connecting with the respective impurity regions of the second group active regions aligned in the one direction and extending in the one direction over the polycrystalline silicon layer on the field region in the proximity of the wide sections, in the plan view, serving as capacitor sections of the first group active regions via a third insulating film, a first group of word lines each connecting with the first group gate electrodes aligned in the direction orthogonal to the one direction and extending in the orthogonal direction, and a second group of word lines each connecting with the second group gate electrodes aligned in the orthogonal direction and extending in the orthogonal direction.

According to another aspect of the present invention, there is provided a process for manufacturing a memory device comprising the steps of selectively forming a field insulating film on a semiconductor substrate of one conductivity type, forming an insulating film serving as a dielectric film of a capacitor on a capacitor section forming region in an active region adjacent to the field insulating film, forming a first polycrystalline silicon layer extending from on the insulating film of a capacitor onto said field insulating film and serving as a capacitor electrode, forming an insulating film on the upper and side surfaces of the first polycrystalline silicon layer, forming a gate insulating film on a channel region in said active region, forming a second polycrystalline silicon layer extending from on said gate insulating film onto the insulating film on the first polycrystalline silicon layer and serving as a gate electrode, forming an impurity region of the opposite conductivity type serving as a source or drain

- 8 -

region in a self-registering fashion by introducing an impurity of the opposite conductivity type through a mask including second polycrystalline silicon layer and the field insulating film, and forming a third polycrystalline silicon layer connected to said impurity region through an aperture in the insulating film thereon and extending on the portion of the first polycrystalline silicon layer above the field insulating film to serve as a data line. The impurity region can be formed by the ion-implantation process.

As described above, according to the present invention, the third polycrystalline silicon layer is used as data lines and these data lines are connected to source or drain regions provided in the narrow sections of the active regions. Accordingly, a junction capacitance between the semiconductor substrate and the data line can become small value, and moreover, since the thickness of the third insulating film can be freely determined, for example, 1.5 $\mu$m or more. Therefore the stray capacitance of the data line can be made small as a whole. By way of example, in contrast to the fact that in the memory device disclosed in U.S. Patent 4,012,757 referred to above a stray capacitance of a data line was 0.7 to 1.0 $\mu$F, according to the present invention it can be suppressed to 0.4 $\mu$F or less. In addition, according to the present invention, the distance between capacitor sections of opposed memory cells with a data line interposed therebetween can be arrayed as close as 0.5$\mu$m to 3 $\mu$m as viewed in a plan configuration. Accordingly, the area of the capacitor section can be increased by the corresponding amount, and by way of example, as compared to the known memory device disclosed in U.S. Patent 4,012,757 above, a capacitance $C_S$ of a capacitor section about 1.5 times can be obtained, provided that the other conditions are made equal between them. Moreover, in the case of employing a data line proposed according to the present invention, between the data line and the semiconductor substrate is positioned the capacitor electrode including of the first polycrystalline silicon layer that is maintained at a constant potential. Consequently, the data line is hardly influenced by a potential variation of the semiconductor substrate.

The above-described memory device according to the present invention can be realized by employing first, second and third polycrystalline silicon layers, respectively, as capacitor electrodes, gate electrodes and data lines, and forming these polycrystalline silicon layers, respectively, in separate steps of a process.

More particularly, by forming the data lines after the capacitor electrodes have been formed, it becomes possible to array the capacitor sections arbitrarily close to each other as viewed in a plan configuration, the thickness of the third insulating film can be made large for the property of polycrystalline which forms the data line and also the shielding effect can be provided. In addition, by forming the data lines after the gate electrodes were formed, the length of the impurity regions serving as source or drain regions can be made small, and hence the PN-junction capacitance can be further reduced. Namely, the size of the aperture in the insulating film above the impurity region can be made smaller than the width of the data line by employing the above-mentioned steps, the length of the impurity region can be reduced by the corresponding amount. In addition, from the same reasons the area of the capacitor section can be further increased.

BRIEF DESCRIPTION OF THE DRAWINGS:

In the accompanying drawings:

Fig. 1 is a circuit diagram of a principal part of a single-transistor type memory device to be used for explaining an operation principle of the device,

Fig. 2A is a plan view showing a memory device in the prior art,

Fig. 2B is a cross-sectional view taken along line B-B' in Fig. 2A as viewed in the direction of arrows,

Figs. 3, 4A, 5A, 6A and 7A are plan views showing successive steps of a manufacturing process of a memory device according to one preferred embodiment of the present invention,

Figs. 4B, 5B 6B and 7B are enlarged cross sectional views taken along lines B-B' in Figs. 4A, 5A, 6A and 7A, respectively, as viewed in the direction of arrows,

Fig. 7C is an enlarged cross-sectional view taken along line C-C' as viewed in the direction of arrows,

Fig. 8A is a plan view of a completed memory device according to the same preferred embodiment of the present invention, and

Fig. 8B is a cross-sectional view taken along line B-B' in Fig. 8A as viewed in the direction of arrows.

DETAILED DESCRIPTION OF THE PRIOR ART:

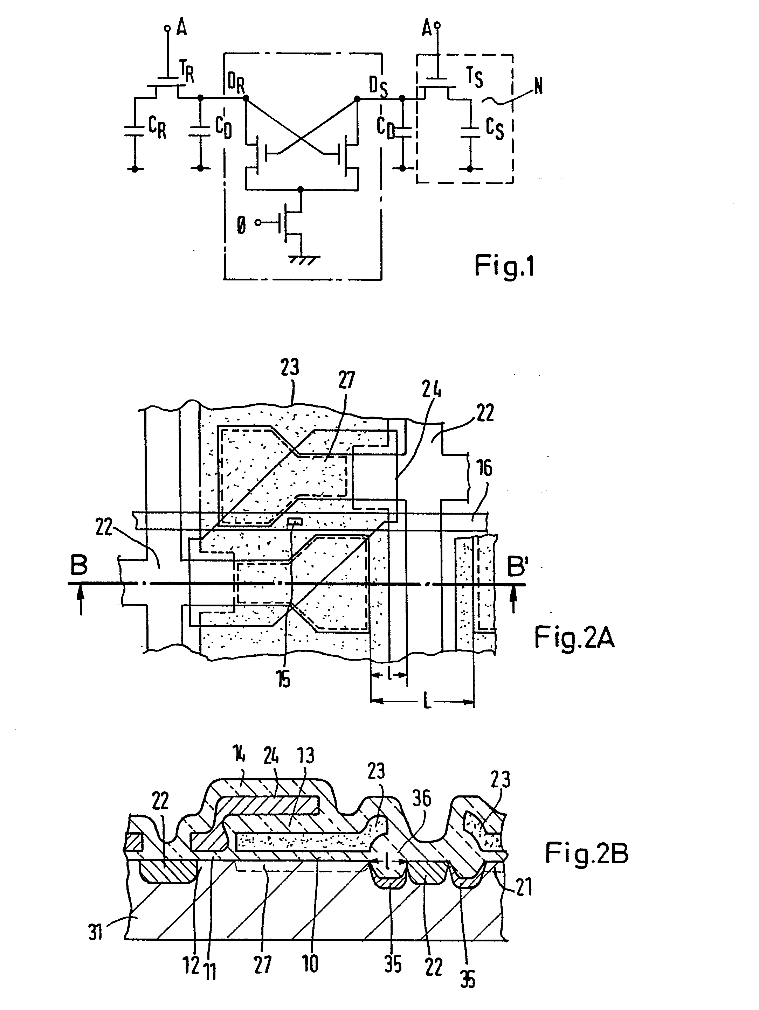

A single-transistor type memory cell means a memory cell for one bit consisting of a single transfer gate $T_S$ and a single cell capacitor $C_S$ as shown within a dash-line frame in Fig. 1, in which information is stored in the form of electric charge Q on the capacitor $C_S$ and upon reading the information stored in the form of electric charge Q is transferred to a data line $D_S$ by opening the transfer gate $T_S$, and the data line $D_S$ has a stray capacitance $C_D$. The cell capacitance $C_S$ is so small that a potential change on the data line $D_S$ produced by the charge transfer is, for example, of the order of 200 mV Therefore, it is common practice to amplify the above-mentioned very small potential change by means of an amplifier called "sense amplifier" as shown within a dash-dot-line frame in Fig. 1 and further transmit the signal to an output as conveyed on another data bus line. It is to be noted that a dummy cell consisting of a single transfer gate $T_R$ and a single cell capacitor $C_S$ in Fig. 1 is provided for the purpose of generating a permanently constant potential on a data line $D_R$ so that this constant potential may be compares with the potential on the data line $D_S$ to which the data from the memory cell have been transferred to determine whether the data are "0" or "1". In Fig. 1, reference symbol A represents an address signal and reference symbol $\phi$ represents a sense amplifier activation signal.

In the illustrated arrangement, the sense amplifier is a differential amplifier, and the larger the initial value of the potential difference between the data lines $D_S$ and $D_R$ serving as an input signal to the sense amplifier is, the faster can be completed the operation, and moreover, the more durable is the sense amplifier against a noise voltage caused by $\alpha$ - rays or coupling capacitances between the data lines and the substrate. As will be apparent from the above description, the initial value of the potential difference between the above-described data lines $D_S$ and $D_R$ is nearly determined by the ratio of a data line stray capacitance $C_D$ to a cell capacitance $C_S$, that is, by the value of the ratio $C_D/C_S$, and the small this value is, the more advantageous is the memory cell.

Whereas, in an IC memory device, due to micro-fining of a circuit pattern caused by high density circuit integration, an occupation area of a cell for one bit is redued and hence the cell capacitance $C_S$ becomes small. On the other hand, because of increase of a memory capacity of an IC memory device, the data line would not become so short, hence the data line stray capacitance $C_D$ is not so much reduced as the cell capacitance $C_S$, and consequently, there exists an intense trend that the ratio $C_D/C_S$ becomes large.

Now, a memory device in the prior art will be explained with reference to Figs. 2A and 2B. In a P-type silicon substrate 31 is selectively formed a field region consisting of a $P^+$-type channel stopper region 35 and a thick silicon oxide film 36. A plurality of

$N^+$-type impurity regions 22 are extending in one direction as delimited by this field region to serve as data lines, and active regions also delimited by the field region project from these data lines in a finger-like configuration. A capacitor section of each active region is constructed of an N-type inversion layer 27, an insulating film 10 and a capacitor electrode 23 including a polycrystalline silicon layer. A gate electrode 24 including a polycrystalline silicon layer is provided above a channel region 12 via a gate insulating film 11 and extends over the capacitor electrode 23 via an insulating film 13. This gate electrode 24 is connected to a word line 16 made of aluminium through an aperture 15 formed in an insulating film 14 thereon.

In the above-described known memory device, since an impurity region extending in a semiconductor substrate is used as a data line, the stray capacitance $C_D$ of the data line is large. In addition, because of the fact that a field region having a length $\ell$ of 0.5 to 3 μm is necessitated between a capacitor section of one memory cell and an adjacent data line connected to other memory cells and hence the distance $\underline{L}$ between capacitor sections of opposed memory cells with a data line (i.e. bit line) interposed therebetween is as large as about 9 μm, the area of the capacitor section is reduced by the corresponding amount, and so, the cell capacitance $C_S$ becomes small.

DESCRIPTION OF THE PREFERRED EMBODIMENT:

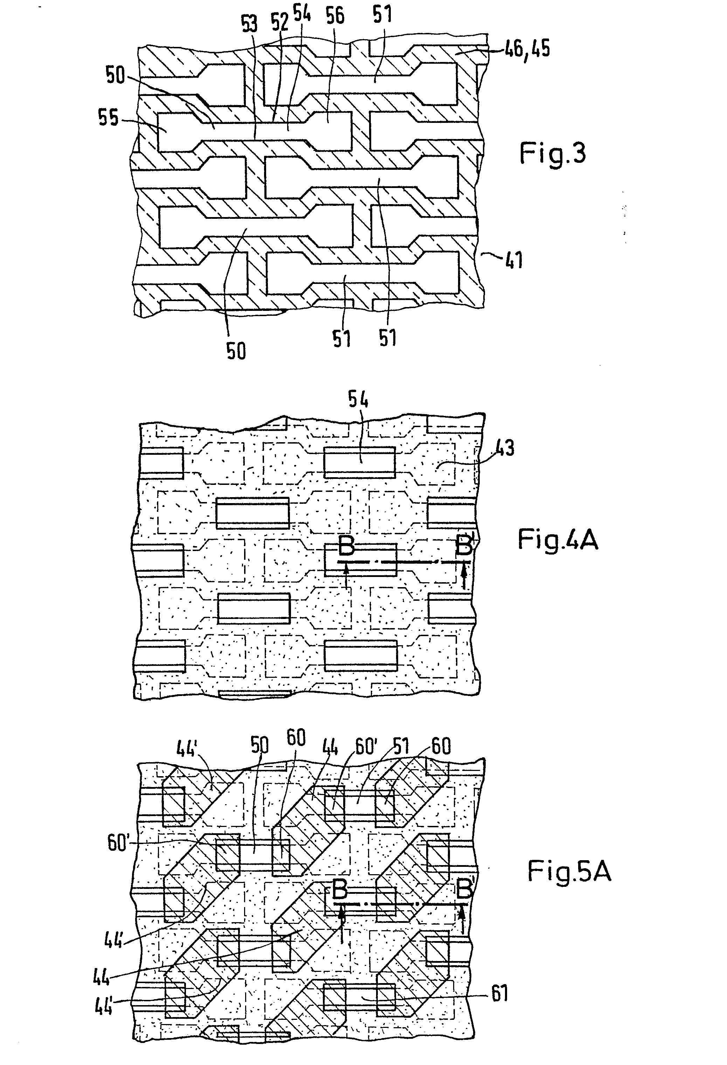

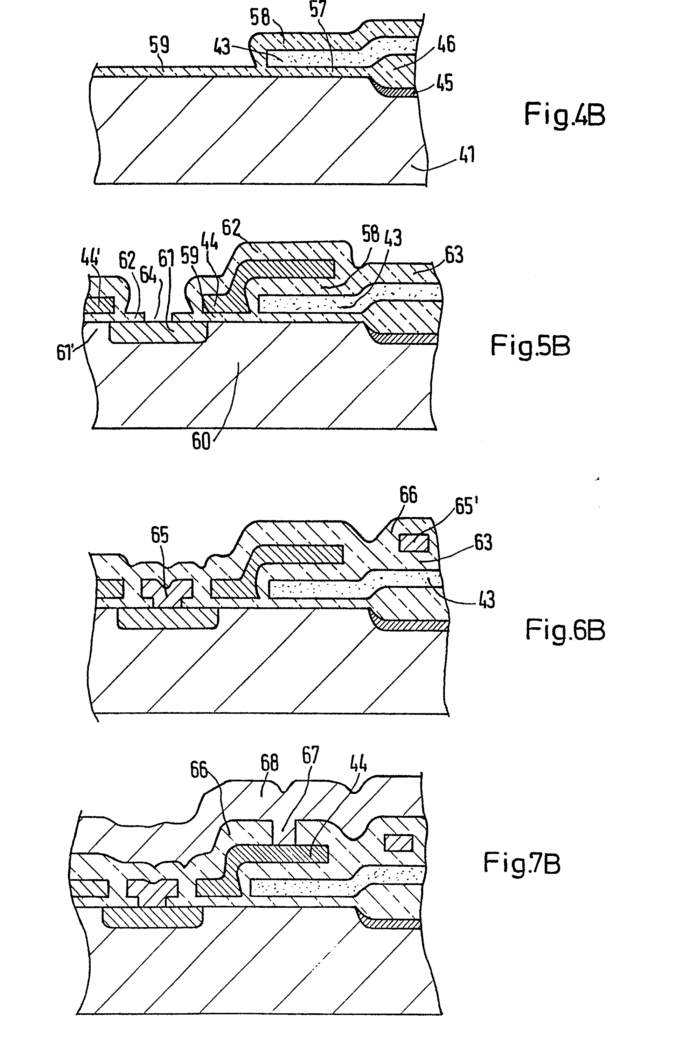

On a major surface of a P-type silicon substrate 41 having a specific resistance of 10 to 20 Ωcm is selectively formed a field region

including a P$^+$-type channel stopper region 45 and a thick silicon oxide film 46. A first group of active regions 50 and a second group of active regions 51 surrounded by this field region have a mutually interlaced configuration. Each of the active regions has a plan configuration of a clavicle-like figure consisting of a narrow section 54 having substantially parallel first and second edge lines 52 and 53 and wide sections 55 and 56 contiguous to the opposite ends of the narrow section 54 (Fig. 3). Then, an oxide film 57 of about 400 Å in thickness is formed on the surface of the active region through thermal oxidation. This oxide film 57 serves as a dielectric film of a capacitor section. Subsequently, a first polycrystalline silicon layer is vapor-grown to a thickness of 5000 Å over the entire surface, an impurity such as posphorus is diffused into the layer to lower a layer resistance, then a part of the active region above the center portion of the narrow section 54 is selectively removed, for example, through a plasma-etching process, and thereby a capacitor electrode 43 (a dotted area in Figs. 4A and 4B) is formed. In this center portion of the narrow region 54 are formed a source/drain region and first and second channel regions. After removing the exposed oxide film 57, the first polycrystalline silicon layer and the semiconductor substract are oxidized within an oxidizing atmosphere to form a silicon oxide film 58 and a gate insulating film 59 (Figs. 4A and 4B).

Subsequently, a second polycrystalline silicon layer is vapor

grown to a thickness of 5000 Å, an impurity such as phosphorus is diffused into the silicon layer, and a part of the diffused layer is selectively removed to form a gate electrode 44 which is disposed above a channel region 60 via the gate insulating film 59 and extends over the capacitor electrode 43 via the silicon oxide film 58. Such gate electrodes are grouped into a first group of gate electrodes 44 each of which extends from the first channel region 60 of the first group active region 50 over the capacitive electrode 43 to the second channel region 60' of the second group active region 51, and a second group of gate electrodes 44' each of which extends from the first channel region 60 of the second group active region 51 over the capacitor electrode 43 to the second channel region 60' of the first group active region 50. The respective gate electrodes are identified by left-upwardly extending hatchings in Figs. 5A, 6A and 7A. Thereafter, $N^+$-type impurity regions 61 serving as source or drain regions which are common to adjacent memory cells on the left and right sides, are formed in a self-registering fashion by introducing arsenic into the surface portions of the substrate through the silicon oxide film 59 by making use of the gate electrodes 44 and 44' and the thick silicon oxide film 46 as a mask, for instance, through an ion-implantation process. Then, a silicon oxide film or a phosphorus glass film is formed through a thermal oxidation process or a vapor-growth process. Thereby an insulating film 62 is deposited on the gate electrode 44 or 44' and on the impurity region 61, and an insulating film 63 is deposited on the capacitor electrode portion above the field region. In this process, the thickness of film 63,62 can be freely large. Then an aperture 64 is provided in the insulating film on the $N^+$-type impurity region 61 (Figs. 5A and 5B).

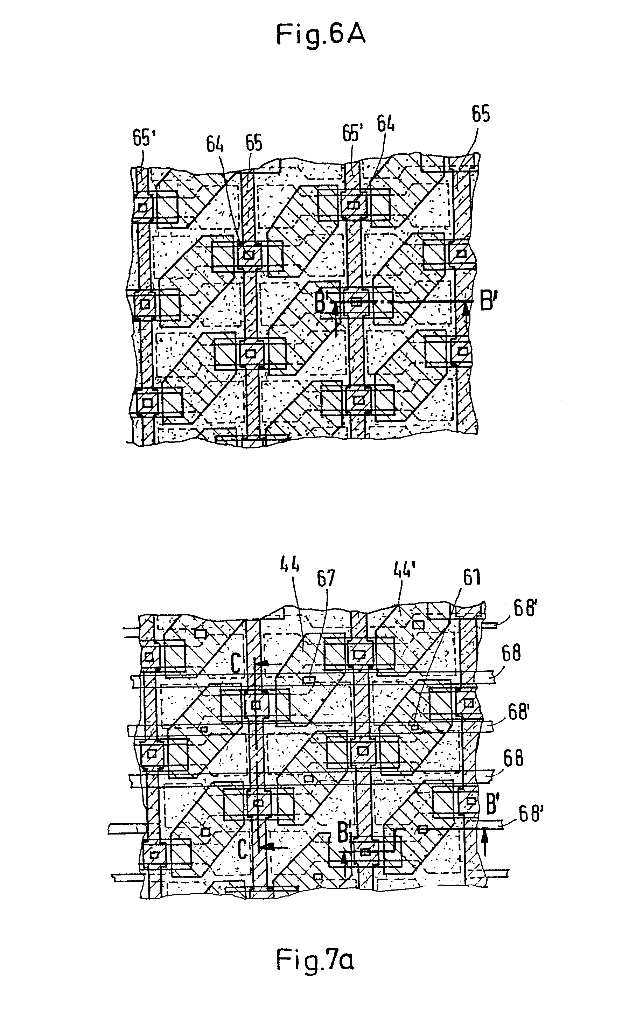

Next, a third polycrystalline silicon layer is vapor-grown to a thickness of 5000 $\overset{\circ}{A}$, and after an impurity such as phosphorus has been introduced into the silicon layer, the doped layer is selectively removed to form data lines 65 and 65' (right-upwardly hatched portions). The data line 65 is connected through the aperture 64 to the impurity region serving as a source or drain region, and extends over the portion of the capacitor electrode 43 on the field region via the insulating film 63 straightly in one direction as viewed in a plan configuration. These data lines are grouped into a first group of data lines 65 which are connected to the impurity regions 61 of the first group of active regions 50, and a second group of data lines 65' which are connected to the impurity regions 61 of the second group of active regions 51. Then an insulating film 66 is deposited through a thermal oxidation process or a vapor-growth process (Figs. 6A and 6B).

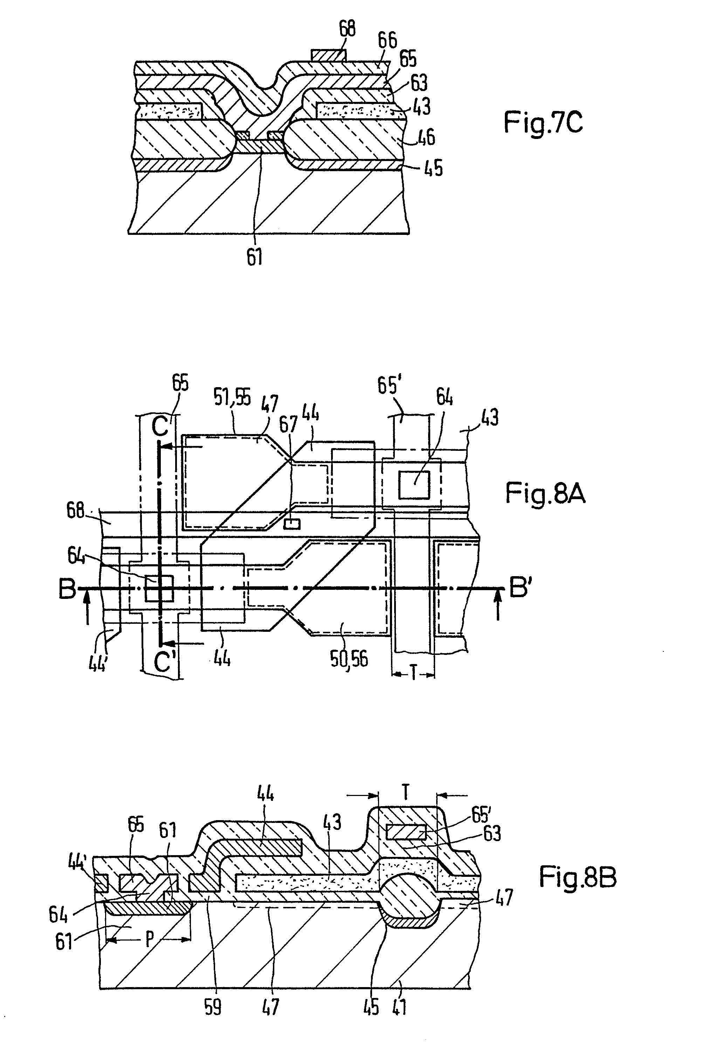

Nextly, apertures 67 are provided in the insulating film 66, an aluminium layer is deposited through a vapor-deposition process or a sputter process, and then the aluminum layer is subjected to patterning to form word lines 68 and 68' connected to the gate electrodes 44 and 44', respectively. These word lines are grouped into a first group of word lines 68 which are connected to the first group of gate electrodes 44, and a second group of word lines 68' which are connected to the second group of gate electrodes 44'. Subsequently, the entire device is coated with a passivation film including a silicon oxide film or a phosphorus glass film (not shown) through a vapor-growth process (Figs. 7A and 7B).

Fig. 8A is an enlarged plan view of a part of the memory device produced through the process shown in Figs. 3 to 7, and Figs. 8B and 8C are cross-sectional views of the same part taken along different lines B-B' and C-C', respectively. in Fig. 8A. It is to be noted that component parts equivalent to those shown in Figs. 3 to 7 are given like reference numerals, and that the passivation film on the word lines is omitted from illustration. In the illustrated construction, as a countermeasure for the case where the capacitor electrode 43 is held at the ground potential, an N-type impurity layer 47 is provided. This impurity layer can be formed in the early period (Fig. 3) of the manufacturing process. However, in the case where the memory device is used while maintaining the capacitor electrode 43 at a positive potential, an N-type inversion layer is induced in place of the impurity layer 47.

As will be obvious from Figs. 8A and 8B, the distance $T$ between capacitor sections of opposed memory cells with the data line 65' interposed therebetween becomes 0.5 to 3 μm. Consequently, in a practical device, a capacitance $C_S$ of a capacitance section is about 1.5 times as large as that of the memory device in the prior art shown in Fig. 2.

- 18 -

In addition, owing to the facts that the data line is not a diffused wiring layer formed in the semiconductor substrate and that the thickness of the insulating film 63 between this data line and the capacitor electrode can be chosen as thick as 1.5 μm or more, the stray capacitance of the entire data line can be reduced to 0.4 pF or less. Recalling the fact that the stray capacitance of the data line in the prior art shown in Fig. 2 amounted to 0.7 to 1.0 pF, this is a great advantage of the present invention.

Furthermore, according to the present invention, the gate electrode 44 is formed from the second polycrystalline silicon layer and the data lines 65 and 65' are formed from the third polycrystalline silicon layer. By employing such method for manufacture, a length $\underline{p}$ of the common source or drain region 61 can be made small, and so, the PN-junction capacitance can be reduced by the corresponding amount.

In more particular, let us consider the case where the polycrystalline silicon layer is formed on the thin insulating film, then the gate electrode and the data line are formed through an etching process, and the impurity region serving as a source or drain region is formed in a self-registering fashion with respect to the gate electrodes 44 and 44' through an ion-implantation process. In this assumed case, since ions cannot penetrate through the overlapped region of the polycrystalline silicon layer and the insulating film, always the aperture 64 is necessitated to be longer than the width

- 19 -

0073019

of the data line.  Taking a margin for registering into consideration, in the case where the width of the data line is 3 μm, an aperture extended by 3 μm on the respective sides of the data line, that is, an aperture having a length of 9 μm is necessitated.  Accordingly, in the case of providing such a long aperture, the length of the impurity region is necessary to be as long as 15 μm, and hence the PN-junction is enlarged by the corresponding amount.

Whereas, according to the present invention, at first the gate electrodes 44 and 44' are formed from the second polycrystalline silicon layer, then the impurity region 61 is surely formed in a self-registering fashion by making use of the gate electrodes 44 and 44' as a mask, thereafter the aperture 64 is formed in the insulating film 62, and subsequently, the data lines 65 and 65' are formed from the third polycrystalline silicon layer.

In the process according to the present invention, since the data lines are formed by polycrystalline silicon after the impurity regions serving as source or drain regions have been surely formed, there is no need to carefully consider so that the data line and the insulating film may not overlap with each other above an intended region for an impurity region.  The aperture 64 formed according to the present invention is not an aperture for introducing an impurity but it is intended only to make contact with a data line, and so, a small aperture can suffice.  Practically, in the case of a data line width of 3 μm, the aperture would have an area of 2.5 μm x 2.5 μm,

and in this case, since the length $\underline{p}$ of the impurity region is as small

as about 9 μm, the PN-junction capacitance also becomes small.

WHAT IS CLAIMED IS:

1.  A memory device having a large number of memory cells arrayed in a matrix form, comprising a semiconductor substrate of one conductivity type, a field region including a thick insulating film provided along one major surface of said semiconductor substrate, a large number of active regions arrayed in a matrix form, each active region having a plan configuration including narrow section and wide sections serving as capacitor regions contiguous to the opposite ends of said narrow section and surrounded by said field region, impurity regions of the opposite conductivity type provided at the centers of the narrow sections of said respective active regions and serving as source or drain regions, first and second channel regions positioned in said narrow sections on the opposite sides of said impurity regions, and contiguous to the respective impurity regions, capacitor electrodes including a first polycrystalline silicon layer provided via a first insulating film above said active regions except for said impurity regions and said first and second channel regions and also provided over the substantially entire surface of said field region, gate electrodes including a second polycrystalline silicon layer disposed above said first channel regions of the respective active regions via a gate insulating film and extending over said first polycrystalline silicon layer via a second insulating film disposed above said second channel regions of the adjacent active regions via a gate insulating film, a large number of data lines including a third polycrystalline silicon layer connecting in common with said impurity regions of a group of active regions arrayed in one direction and extending in said one direction over said first polycrystalline silicon layer on said field region between the respective active regions via a third insulating film, and a large number of word lines extending in the direction at right angles to said one direction and connecting with said respective gate electrodes.

2. A memory device comprising a semiconductor substrate of one conductivity type, a field region including a thick insulating film provided along one major surface of said semiconductor substrate, a first group of active regions arrayed in a matrix form as aligned in predetermined orthogonal directions, each said active region having a plan configuration including a narrow section having first and second edge lines which are substantially parallel to each other and wide sections provided contiguously to the opposite ends of said narrow section and surrounded by said field region, a second group of active regions arrayed in a matrix form as aligned in said predetermined orthogonal directions, each said active region having a plan configuration including a narrow section having first and second edge lines which are substantially parallel to each other and wide sections provided contiguously to the opposite ends of said narrow section and surrounded by said field region, said second group active regions being interlaced between said first group active regions in such manner that said wide section of said second group active region is opposed to said narrow section of said first group active region and said narrow section of said second group active region is opposed to said wide section of said first group active region, impurity regions of the opposite conductivity type provided at the centers of said narrow sections of the respective active regions and serving as source or drain regions, first and second channel regions positioned in the portions of said narrow sections contiguous to said impurity regions, capacitor electrodes including a first polycrystalline silicon layer provided via a first insulating film above said active regions except for said impurity region and said first and second channel regions and also provided substantially over the entire surface of said field region, a first group of gate electrodes including a second polycrystalline silicon layer, each said first group gate electrode being disposed above said first channel region of one first group active region via a gate insulating film and extending over said first polycrystalline silicon layer via a second insulating film to be disposed above said second channel region of the adjacent second group active region via a gate insulating film, a second group of gate electrodes including said second polycrystalline silicon layer, each said second group gate electrode being disposed above said second channel region of one second group active region via a gate insulating film and extending over said first polycrystalline silicon layer via a second insulating

film to be disposed above said first channel region of the adjacent second group active region via a gate insulating film, a first group of data lines including a third polycrystalline silicon layer, each said first group data line connecting with the respective impurity regions of said first group active regions aligned in one direction of said predetermined orthogonal directions and extending in said one direction over said first polycrystalline silicon layer on said field region in the proximity of said wide sections, in the plan view, serving as capacitor sections of said second group active regions via a third insulating film, a second group of data lines including said third polycrystalline silicon layer, each said second group data line connecting with the respective impurity regions of said second group active regions aligned in said one direction and extending in said one direction over said polycrystalline silicon layer on said field region in the proximity of said wide sections, in the plan view, serving as capacitor sections of said first group active regions via a third insulating film, a first group of word lines each connecting with said first group gate electrodes aligned in the direction orthogonal to said one direction and extending in said orthogonal direction, and a second group of word lines each connecting with said second group gate electrodes aligned in said orthogonal direction and extending in said orthogonal direction.

3.  A memory device as claimed in Claim 1 or 2, in which said word lines are made of aluminium.

4.   A memory device as claimed in Claim 1 or 2, in which said field region includes a thick insulating film and a high concentration region of one conductivity type disposed under said thick insulating film.

5.   A memory device as claimed in Claim 1 or 2, in which said third insulating film has a film thickness of 1.5 μm or more.

6.   A memory device as claimed in Claim 1 or 2, in which a distance between capacitor sections of opposed memory cells with said data line interposed therebetween ranges from 0.5 μm to 3 μm as viewed in a plan configuration.

7.   A process for manufacturing a memory device comprising the steps of selectively forming a field insulating film on a semiconductor substrate of one conductivity type, forming a first insulating film on a capacitor forming region in an active region adjacent to said field insulating film, forming a first polycrystalline silicon layer extending from the surface of said first insulating film onto said field insulating film and serving as a capacitor electrode, forming a second insulating film on the upper and side surfaces of said first polycrystalline silicon layer, forming a gate insulating film on a channel region in said active region, forming a second polycrystalline silicon layer extending from the surface of said gate insulating film to said second insulating film on said first polycrystalline silicon layer and serving as a gate electrode,

- 26 -

0073019

forming an impurity region of the opposite conductivity type serving as a source or drain region, and thereafter forming a third polycrystalline silicon layer connected to said impurity region and extending in one direction to serve as a data line.

8. A process for manufacturing a memory device as claimed in Claim 7, in which said impurity region is formed by making said second polycrystalline silicon as a mask.

9. A process for manufacturing a memory device as claimed in Claim 7, in which after said impurity region has been formed, an aperture is formed in an insulating film on said impurity region, and thereafter said third polycrystalline silicon layer is connected to said impurity region through said aperture.

Fig.1

Fig.2A

Fig.2B

Fig.3

Fig.4A

Fig.5A

0073019

Fig.4B

Fig.5B

Fig.6B

Fig.7B

Fig.6A

Fig.7a

Fig.7C

Fig.8A

Fig.8B